# EUROPEAN PATENT APPLICATION

(11) **EP 2 658 283 A1**
(43) Date of publication of application: **30.10.2013**
(21) Application number: 11851270.6
(22) Date of filing: 24.11.2011
(51) Int. Cl.: H04R 17/00, G01S 7/521, G01S 15/08, H04R 3/00

(54) **OSCILLATOR DEVICE AND ELECTRONIC INSTRUMENT**

(30) Priority: 20.12.2010 JP 2010282674
(71) Applicant: NEC CASIO Mobile Communications, Ltd., Kawasaki-shi Kanagawa 211-8666 (JP)
(72) Inventor: ONISHI, Yasuharu, Kawasaki-shi, Kanagawa 211-8666 (JP); KURODA, Jun, Kawasaki-shi, Kanagawa 211-8666 (JP); KISHINAMI, Yuichiro, Kawasaki-shi, Kanagawa 211-8666 (JP); MURATA, Yukio, Kawasaki-shi, Kanagawa 211-8666 (JP); SATOU, Shigeo, Kawasaki-shi, Kanagawa 211-8666 (JP); KAWASHIMA, Nobuhiro, Kawasaki-shi, Kanagawa 211-8666 (JP); KOMODA, Motoyoshi, Kawasaki-shi, Kanagawa 211-8666 (JP); UCHIKAWA, Tatsuya, Kawasaki-shi, Kanagawa 211-8666 (JP)
(74) Representative: Vossius & Partner
(86) International application number: PCT/JP2011/006521
(87) International publication number: WO 2012/086125

(57) **Abstract**

In an electro-acoustic transducer 100 which is an oscillator device, a flat piezoelectric film 120 that moves expansively and contractively through the application of an electric field is disposed on at least one surface of a flat elastic member 110 in which a plurality of holes 111 penetrate a principal surface thereof. Since the stiffness of the elastic member 110 is adjusted by the holes 111, the stiffness impedance with respect to the piezoelectric film 120 can be matched optimally. Thus, it is possible to suppress the amount of vibration displacement and to complement the conversion efficiency of the piezoelectric film 120.

## Description

### TECHNICAL FIELD

The present invention relates to an oscillator device including a piezoelectric film, and an electronic instrument using the oscillator device.

### BACKGROUND ART

In cellular phones, sound functions such as music reproduction or hands-free are required to be enhanced. Accordingly, there is increasing demand for cellular phones that are made small and thin and that has a high-quality sound. As means to respond to the demand, piezoelectric electro-acoustic transducers using a piezoelectric element as an oscillation source have been developed. Since the piezoelectric electro-acoustic transducers use a self-expansion and contraction motion of the piezoelectric element, the piezoelectric electro-acoustic transducers are thinner than electrodynamic electro-acoustic transducers constituted by a magnetic circuit.

At present, various types of electro-acoustic transducers have been proposed (for example, Patent Document 1).

### RELATED DOCUMENT

### PATENT DOCUMENT

[Patent Document 1] Japanese Unexamined Patent Publication No. 2006-287480

### DISCLOSURE OF THE INVENTION

Generally, piezoelectric ceramics which are brittle material are used as a piezoelectric element. The piezoelectric ceramics have many problems, such as processing costs and mechanical strength, in order to be used as an audio component for a cellular phone. As means for solving these problems, a piezoelectric film formed of a polymer material is used. Since the piezoelectric film is formed of a resin material rich in flexibility, the piezoelectric film has a high drop impact stability. However, the conversion efficiency of the piezoelectric film is lower than that of piezoelectric ceramics. Thus, in electro-acoustic transducers using the piezoelectric film, a technique to achieve a high sound pressure level is required.

The invention is contrived in view of such circumstances, and an object of thereof is to provide a piezoelectric oscillator device capable of increasing a sound pressure level while using a piezoelectric film, and an electronic instrument using the oscillator device.

An oscillator device of the invention includes a piezoelectric vibrator that includes an elastic member having a plurality of through holes and a piezoelectric film that is disposed on one surface of the elastic member and is formed of a polymer material, and a supporting member that supports an outer circumferential portion of the piezoelectric vibrator.

A first electronic instrument of the invention includes the oscillator device of the invention, and an oscillation driving unit that causes the oscillator device to output ultrasonic waves demodulated into sound waves of an audible zone.

A second electronic instrument of the invention includes the oscillator device of the invention, an oscillation driving unit that causes the oscillator device to output the ultrasonic waves, an ultrasonic wave detection unit that detects sound waves having the same frequency as the ultrasonic waves, and a distance measurement unit that measures a distance to an object to be measured on the basis of the detected ultrasonic waves.

According to the oscillator device of the invention, it is possible to increase a sound pressure level while using a piezoelectric film.

### BRIEF DESCRIPTION OF THE DRAWINGS

The above-described objects, other objects, features and advantages will be further apparent from the preferred embodiments described below, and the accompanying drawings as follows.

FIG. 1 is a schematic vertical cross-sectional front view illustrating a structure of an electro-acoustic transducer which is an oscillator device of an embodiment of the invention.
FIG. 2 is a schematic exploded perspective view illustrating a structure of the electro-acoustic transducer.
FIG. 3 is a schematic exploded perspective view illustrating a structure of an electro-acoustic transducer according to a modified example.
FIG. 4 is a diagram illustrating a configuration of an electronic instrument according to a modified example.

### DESCRIPTION OF EMBODIMENTS

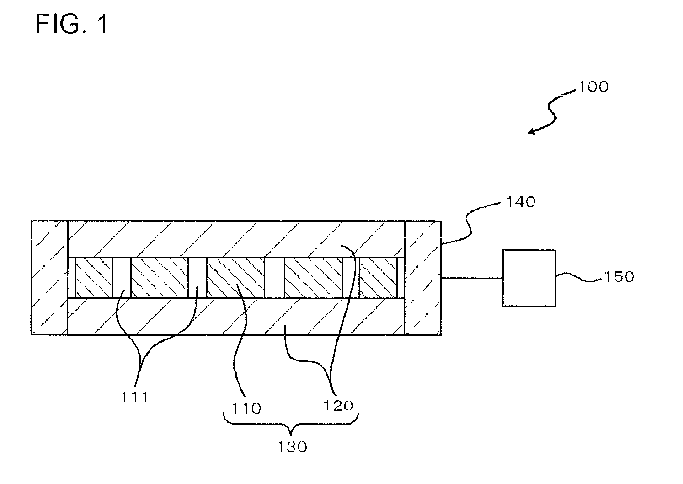

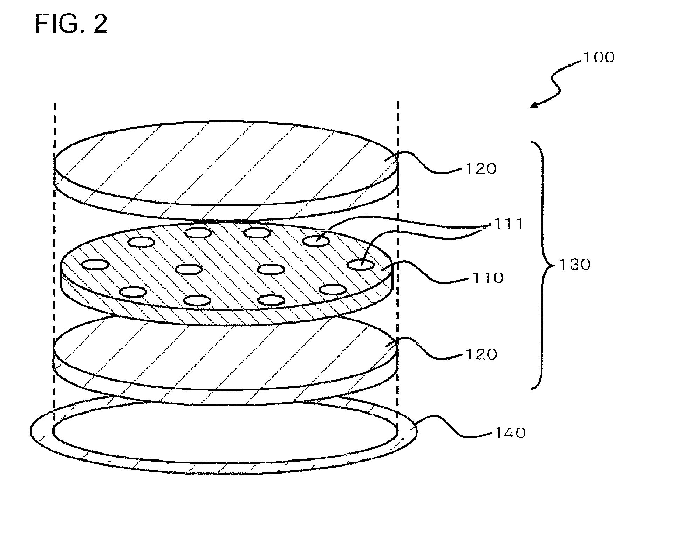

Hereinafter, an electro-acoustic transducer 100 which is an oscillator device of the embodiment will be described with reference to FIGS. 1 and 2. The electro-acoustic transducer 100 of the embodiment includes a piezoelectric vibrator 130 and a supporting member 140. The piezoelectric vibrator 130 includes an elastic member 110 and a piezoelectric film 120. The elastic member 110 includes a plurality of holes 111. The holes 111 vertically penetrate the elastic member 110. The piezoelectric film 120 is disposed on one surface of the elastic member 110, and moves expansively and contractively through the application of an electric field. The supporting member 140 supports an outer circumferential portion of the piezoelectric vibrator 130. In the examples illustrated in FIGS. 1 and 2, the supporting member 140 has a frame shape and supports the whole outer circumference of the elastic member 110.

The elastic member 110 is, for example, phosphor bronze or stainless steel. The thickness of the elastic member 10 is preferably equal to or more than 5 µm and equal to or less than 1000 µm. When the thickness of the elastic member 110 is less than 5 µm, mechanical strength is low, and thus there is a possibility that functions as a constraint member may be damaged. In addition, there is a possibility that variation in machinery vibration characteristics of a vibrator occurs between production lots due to a reduction in processing accuracy. In addition, it is preferable that the elastic member 110 have a longitudinal elastic modulus, which is an index indicating stiffness, of equal to or more than 1 Gpa and equal to or less than 500 GPa.

At least one of the holes 111 overlaps with the piezoelectric film 120. For example, in the examples illustrated in FIGS. 1 and 2, the piezoelectric film 120 covers substantially the entire surface of the elastic member 110. Thus, all the holes 111 overlap with the piezoelectric film 120. The stiffness impedance of the elastic member 110 with respect to the piezoelectric film 120 is adjusted according to the sizes, number, and positions of the holes 111. The diameter of the hole 111 is determined in response to various conditions. In addition, a ratio of the total areas of the holes 111 to an area of a principal surface of the elastic member 110 is also determined in response to various conditions. When the plane surface of the elastic member 110 has a circular shape, at least some of the holes 111 are arranged at equal intervals along the same circular ring. For example, the holes 111 are equally dispersed on the entire surface of the elastic member 110, but the holes 111 may be formed so as to be biased to a specific region.

Meanwhile, in the example illustrated in FIG. 2, the elastic member 110 and the piezoelectric film 120 are formed in the form of a disk, and the supporting member 140 is formed in an annular shape. However, the supporting member 140 may be formed in a rectangular shape after the elastic member 110 and the piezoelectric film 120 are formed in a rectangular shape (for example, oblong shape or square shape).

In the piezoelectric vibrator 130 of the embodiment, the piezoelectric film 120 is disposed on both surfaces of the elastic member 110. An electrode layer (not shown) is also formed on both surfaces of the piezoelectric film 120, and thus the piezoelectric vibrator 130 is constituted by the electrode layer, the piezoelectric films 120, and the elastic member 110.

The piezoelectric film 120 is formed of, for example, a polyvinylidene fluoride (PVDF) resin. Although a material of the electrode layer formed in the piezoelectric film 120 is not particularly limited, the material is, for example, silver or silver/palladium. Since silver is used as a low-resistance versatile electrode material, there is an advantage in a manufacturing process or cost and the like. Since silver/palladium is a low-resistance material excellent in oxidation resistance, there is an advantage from the viewpoint of reliability.

In addition, although the thickness of the electrode layer is not particularly limited, the thickness is preferably 1 µm to 100 µm. In the thickness of less than 1 µm, since a film thickness is thin, it is difficult to uniformly form the electrode layer, and thus there is a possibility of the conversion efficiency decreasing. In addition, when the thickness of the electrode layer exceeds 100 µm, there is no particular manufacturing problem, but the electrode layer serves as a constraint surface with respect to the piezoelectric film 120, and thus there is a possibility of the energy conversion efficiency being caused to decrease.

A driver circuit 150 which is an oscillation driving unit is connected to the piezoelectric vibrator 130. The driver circuit 150 causes the piezoelectric vibrator 130 to output sound waves by inputting an oscillation signal. For example, the oscillation signal has the same frequency as a fundamental resonance frequency of the piezoelectric vibrator 130. In detail, when a signal is input to the piezoelectric film 120 of the piezoelectric vibrator 130, an expansion and contraction motion occurs in the piezoelectric film 120 and the elastic member 110. Sound waves are generated by the expansion and contraction vibration. When the electro-acoustic transducer 100 is used as a parametric speaker, the piezoelectric vibrator 130 oscillates ultrasonic waves. The frequency of the ultrasonic waves is, for example, 20 kHz or more.

The fundamental resonance frequency of the piezoelectric vibrator 130 is influenced by the shape and size of the piezoelectric film 120. It is preferable that the size of the piezoelectric film 120 be reduced in order to adjust a resonance frequency in a high frequency band, for example, an ultrasonic wave band. Thus, it is likely to reduce the size of the electro-acoustic transducer 100.

Meanwhile, when the oscillator device functions as a parametric speaker, the driver circuit 150 causes the piezoelectric film 120 to oscillate ultrasonic waves on which, for example, FM (Frequency Modulation) or AM (Amplitude Modulation) is performed. The ultrasonic waves are demodulated into audible sounds through a non-linear state (sparse and dense state) of air.

Next, operations and effects of the embodiment will be described. In the electro-acoustic transducer 100 of the embodiment, the plurality of holes 111 are formed in the elastic member 110. Thus, the stiffness impedance with respect to the piezoelectric film 120 can be matched optimally by controlling the number, positions, areas, and the like of the holes 111. Therefore, it is possible to increase a sound pressure level of the sound waves oscillated by the electro-acoustic transducer 100.

In addition, the piezoelectric film 120 is provided on both surfaces of the elastic member 110. In other words, since the piezoelectric vibrator 130 has a bimorph structure, the sound pressure level of the sound waves oscillated by the electro-acoustic transducer 100 further increases.

Meanwhile, the invention is not limited to the embodiment, and allows various modifications thereof without departing from the scope of the invention. For example, in the above embodiment, a bimorph structure has been exemplified in which a respective one of a pair of piezoelectric films 120 is disposed on the both surfaces of the elastic member 110. However, it is also possible to implement a unimorph structure in which the piezoelectric film 120 is disposed on only a single-sided surface of the elastic member 110.

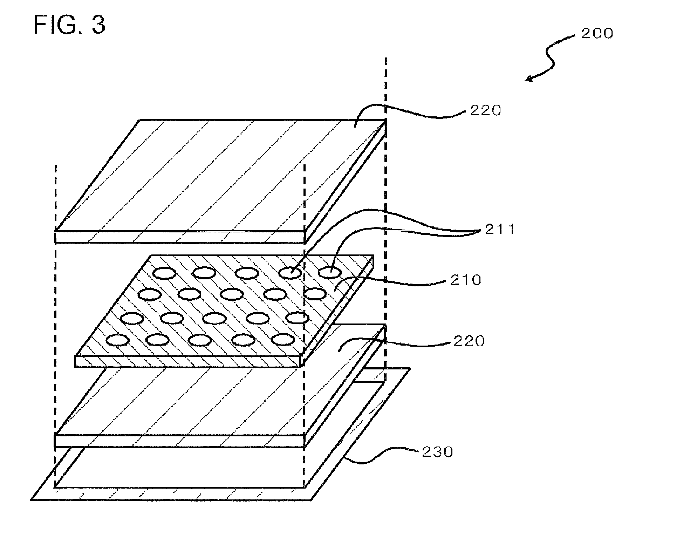

In addition, in the above embodiment, as illustrated in FIG. 2, the elastic member 110 and the piezoelectric film 120 are formed in the form of a disk, and the supporting member 140 is formed in an annular shape. However, like an electro-acoustic transducer 200 illustrated in FIG. 3 as the oscillator device, a supporting member 230 may be formed in a rectangular frame shape after the plane surfaces of the elastic member 210 and the piezoelectric film 220 are formed in a rectangular shape, for example, an oblong shape or a square shape. In the electro-acoustic transducer 200, holes 211 of the elastic member 210 are formed at positions serving as, for example, grid points.

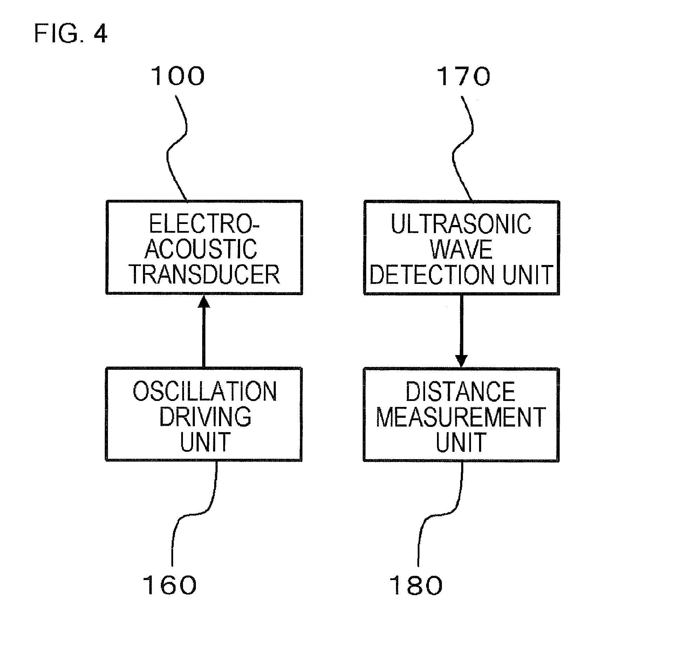

Further, in the above embodiment, the electronic instrument in which the driver circuit 150 which is an oscillation driving unit is connected to the electro-acoustic transducer 100 has been assumed. However, as illustrated in FIG. 4, the electronic instrument may be a sonar including the electro-acoustic transducer 100, an oscillation driving unit 160 that causes the electro-acoustic transducer 100 to output ultrasonic waves, an ultrasonic wave detection unit 170 that detects sound waves (for example, ultrasonic waves reflected by an object to be measured) having the same frequency as the ultrasonic waves oscillated from the electro-acoustic transducer 100, and a distance measurement unit 180 that measures a distance to the object to be measured on the basis of the detected ultrasonic waves.

Meanwhile, as a matter of course, the above-described embodiments and the above-described modified examples can be combined within a range in which contents thereof do not conflict with each other. Additionally, in the above-described embodiments and the above-described modified examples, structures and the like of components have been described in detail, but the structures can be changed in various ways within a range satisfying the invention.

The application claims the priority based on Japanese Patent Application No. 2010-282674 filed on December 20, 2010, the content of which is incorporated herein by reference.

## Claims

1. An oscillator device comprising:
a piezoelectric vibrator that includes an elastic member having a plurality of through holes, and a piezoelectric film that is disposed on one surface of the elastic member and is formed of a polymer material; and
a supporting member that supports an outer circumferential portion of the piezoelectric vibrator.

2. The oscillator device according to claim 1, wherein the piezoelectric film is disposed on each of both surfaces of the elastic member.

3. The oscillator device according to claim 1 or 2, wherein the elastic member is formed of a metal.

4. The oscillator device according to any one of claims 1 to 3, wherein the stiffness impedance of the elastic member with respect to the piezoelectric film is adjusted by the formed holes.

5. The oscillator device according to any one of claims 1 to 4, wherein at least one of the through holes overlaps with the piezoelectric film.

6. An electronic instrument comprising:
the oscillator device according to any one of claims 1 to 5; and
an oscillation driving unit that causes the oscillator device to output ultrasonic waves demodulated into sound waves of an audible zone.

7. An electronic instrument comprising:
the oscillator device according to any one of claims 1 to 5;
an oscillation driving unit that causes the oscillator device to output the ultrasonic waves;
an ultrasonic wave detection unit that detects sound waves having the same frequency as the ultrasonic waves; and
a distance measurement unit that measures a distance to an object to be measured on the basis of the detected ultrasonic waves.
